(19) Europäisches Patentamt
European Patent Office
Office européen des brevets

(11) **EP 4 607 215 A1**

(12) **EUROPEAN PATENT APPLICATION**
published in accordance with Art. 153(4) EPC

(43) Date of publication:
**27.08.2025 Bulletin 2025/35**

(21) Application number: **24842152.1**

(22) Date of filing: **24.06.2024**

(51) International Patent Classification (IPC):
***G01R 31/367*** (2019.01)   ***G01R 31/387*** (2019.01)

(52) Cooperative Patent Classification (CPC):
**G01R 31/367; G01R 31/3842; G01R 31/389**

(86) International application number:
**PCT/CN2024/100881**

(87) International publication number:
**WO 2025/016154 (23.01.2025 Gazette 2025/04)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **18.07.2023  CN 202310884347**

(71) Applicant: **Solax Power Network
Technology (Zhejiang) Co., Ltd.
Zhejiang 311599 (CN)**

(72) Inventors:
• **YAO, Zhenfei
Hangzhou, Zhejiang 311599 (CN)**
• **SONG, Su
Hangzhou, Zhejiang 311599 (CN)**

(74) Representative: **Bandpay & Greuter
11, rue Christophe Colomb
75008 Paris (FR)**

(54) **BATTERY SOC ESTIMATION METHOD AND APPARATUS, AND ENERGY STORAGE DEVICE**

(57)    The present invention discloses a battery SOC estimation method and apparatus. The method includes: calling an equivalent circuit model of a to-be-tested battery, and acquiring offline parameters of the to-be-tested battery; calculating alternately a first SOC value of the to-be-tested battery and online parameters of the to-be-tested battery based on the equivalent circuit model and the offline parameters, and selecting the first SOC value, obtained after the calculation is performed for a preset number of times, as an SOC estimation value; and calculating a current SOC value of the to-be-tested battery according to the SOC estimation value. By using an embodiment of the present invention, problems of accuracy reduction and an SOC jump, caused by only using the offline parameters to estimate an SOC, are solved, and influence of electric current accuracy and temperature, caused by only using an ampere-hour integration method, is reduced, thereby improving estimation accuracy and stability.

FIG. 1

## Description

This application claims priority to Chinese patent application No. 202310884347.6, filed with the China National Intellectual Property Administration on July 18, 2023 and entitled "BATTERY SOC ESTIMATION METHOD, APPARATUS, AND ENERGY STORAGE DEVICE", which is hereby incorporated by reference in its entirety.

## TECHNICAL FIELD

The present invention relates to the technical field of a battery state estimation, in particular to a battery SOC estimation method, apparatus, and energy storage device.

## BACKGROUND

A state of charge (State of Charge, SOC) is one of core parameters of a battery management system, which can reflect a ratio of available energy to total energy of a battery, so an accurate estimation of an SOC plays a huge role in optimizing battery performance; and since an SOC cannot be directly measured by a device, it is of great significance to find a method to estimate the SOC accurately. The existing methods for estimating a battery SOC include an ampere-hour integration method and a Kalman filtering algorithm, etc. Here, the ampere-hour integration method is easily influenced by electric current accuracy and temperature, and an SOC estimation accuracy is limited. Whereas the Kalman filtering algorithm cannot make a good estimation of a battery aging program. As the battery ages, the SOC estimation accuracy will gradually decrease. Moreover, when the SOC is not accurate, and in the Kalman filtering algorithm a current SOC is converged to a true value through a gain adjustment, unreasonable situations may occur, such as an SOC jump, or an SOC drop during charging and an SOC rise during discharging.

## SUMMARY

The present invention provides a battery SOC estimation method, apparatus, and energy storage device, to solve the technical problem of relatively low estimation accuracy when a battery SOC estimation is performed in the prior art.

In order to solve the above technical problem, an embodiment of the present invention provides a battery SOC estimation method, including:

calling an equivalent circuit model of a to-be-tested battery, and acquiring offline parameters of the to-be-tested battery;
calculating alternately a first SOC value of the to-be-tested battery and online parameters of the to-be-tested battery based on the equivalent circuit model and the offline parameters, and selecting the first SOC value, obtained after the calculation is performed for a preset number of times, as an SOC estimation value; and
calculating a current SOC value of the to-be-tested battery according to the SOC estimation value.

In the present invention, on one hand, the offline parameters are used to estimate an SOC, and the online parameters of the to-be-tested battery are calculated for estimating the SOC, forming a closed loop. The problems of accuracy reduction and an SOC jump, caused by only using the offline parameters to estimate the SOC, are solved, and influence of electric current accuracy and temperature, caused by only using an ampere-hour integration method, is reduced, thereby improving estimation accuracy and stability.

Further, the calculating alternately the first SOC value of the to-be-tested battery and the online parameters of the to-be-tested battery based on the equivalent circuit model and the offline parameters, and selecting the first SOC value, obtained after the calculation is performed for the preset number of times, as the SOC estimation value specifically includes:

establishing a first state equation with an SOC and polarization voltages as state variables according to the equivalent circuit model, and establishing a second state equation with parameters of the to-be-tested battery as state variables;
SOC calculation: after substituting the battery parameters into the first state equation, obtaining the first SOC value by using a Kalman filtering algorithm through calculation for the preset number of times;
after substituting the first SOC value into the second state equation, calculating and obtaining the online parameters by using the Kalman filtering algorithm; and
returning to the step of the SOC calculation, and taking the first SOC value obtained by recalculation as the SOC estimation value, where the battery parameters include the offline parameters and online parameters obtained by last calculation.

In the present invention, the SOC of the to-be-tested battery is estimated by using the Kalman filtering algorithm according to the offline parameters or the online parameters. In addition, the Kalman filtering algorithm is further used to update the online parameters according to the estimated SOC, and loop iteration is performed. The problems of gradual reduction of estimation accuracy and jumps of estimation results caused by only using the Kalman filtering algorithm are solved.

Further, the establishing the first state equation with the SOC and the polarization voltages as the state variables according to the equivalent circuit model specifically includes:

establishing a state space equation with an SOC of the equivalent circuit model and voltage parameters of the equivalent circuit model as variables; and
according to the state space equation, establishing the first state equation of the equivalent circuit model.

Further, the after substituting the battery parameters into the first state equation, calculating and obtaining the first SOC value by using the Kalman filtering algorithm specifically includes:

acquiring an initial SOC value, and setting first initial values of the Kalman filtering algorithm based on the initial SOC value;
first parameter calculation: according to the first initial values and the battery parameters, calculating an SOC priori state value at a current time point and a first prior covariance at the current time point;
according to a first derivative of a voltage observation value and a voltage state value of the to-be-tested battery and the first prior covariance, calculating a first Kalman gain matrix at the current time point;
calculating a terminal voltage at the current time point according to the SOC priori state value, an open circuit voltage of the equivalent circuit model and an ohmic internal resistance of the equivalent circuit model;
updating an SOC state value and a covariance according to the terminal voltage, the SOC priori state value and the first Kalman gain matrix;
judging whether a number of times for execution of the step of the first parameter calculation reaches a preset number of calculation times;
when the number of times for execution reaches the preset number of calculation times, setting an updated SOC state value to the first SOC value; and
when the number of times for execution does not reach the preset number of calculation times, returning to the step of the first parameter calculation.

In the present invention, through continuous estimation of the SOC of the to-be-tested battery through the offline parameters and the continuously updated online parameters, the problems of gradual reduction of estimation accuracy and jumps of estimation results, caused along with a decrease of battery performance, caused by only using the offline parameters, are solved.

Further, the after substituting the first SOC value into the second state equation, calculating and obtaining the online parameters by using the Kalman filtering algorithm specifically includes:

setting second initial values of the Kalman filtering algorithm according to the first SOC value;
second parameter calculation: calculating iteratively a second derivative of a voltage observation value with respect to a voltage state value of the to-be-tested battery;
calculating priori state values of the parameters of the to-be-tested battery and a second prior covariance according to the second initial values;
calculating a second Kalman gain matrix according to the second prior covariance and the second derivative; and
updating state values of the parameters of the to-be-tested battery and a covariance according to the second prior covariance, the second Kalman gain matrix and the second derivative, to obtain the online parameters, and returning to the step of the second parameter calculation.

In the present invention, according to the SOC estimated by the Kalman filtering algorithm, the battery parameters are used as variables of a dynamic equation for calculation, which realizes estimation and updating of the online parameters, and the updated parameters are reused in step S12 to realize loop iteration. The problems of gradual reduction of accuracy and jumps of estimation results caused by only using the offline parameters, when using the Kalman filtering algorithm to estimate the SOC, are solved.

Further, the calculating the current SOC value of the to-be-tested battery according to the SOC estimation value specifically includes:

according to the SOC estimation value, determining an ampere-hour integration coefficient of the to-be-tested battery during a charging-discharging process, where the SOC estimation value includes: a current SOC estimation value, a second SOC value corresponding to a highest cell voltage of the to-be-tested battery, and a third SOC value corresponding to a lowest cell voltage of the to-be-tested battery; and

acquiring a current first current value of the to-be-tested battery, and performing an ampere-hour integration calculation according to the first current value and the ampere-hour integration coefficient, to obtain the current SOC value.

In the present invention, firstly a double Kalman filtering algorithm is used to acquire an estimation result with relatively high accuracy, and then a current SOC of the to-be-tested battery is calculated by combining a time-based integration method, thus the technical problem of the estimation result being influenced by electric current accuracy and temperature, caused by only using the ampere-hour integration method, is solved.

Further, the equivalent circuit model is a third-order RC equivalent circuit model.

In the present invention, the third-order RC equivalent circuit model is used, compared with the prior art using a second-order model, the state of the to-be-tested battery can be better reflected, and the accuracy of the estimation result is higher.

Further, the acquiring the offline parameters of the to-be-tested battery specifically includes:
performing an HPPC test on the to-be-tested battery at a preset temperature point, and acquiring the offline parameters of the to-be-tested battery under different SOCs.

In another aspect, an embodiment of the present invention further provides a battery SOC estimation apparatus, including:

a parameter acquiring module, configured to call an equivalent circuit model of a to-be-tested battery, and acquire offline parameters of the to-be-tested battery;

an iteratively estimating module, configured to calculate alternately a first SOC value of the to-be-tested battery and online parameters of the to-be-tested battery based on the equivalent circuit model and the offline parameters, and select the first SOC value, obtained after the calculation is performed for a preset number of times, as an SOC estimation value; and

an SOC calculating module, configured to calculate a current SOC value of the to-be-tested battery according to the SOC estimation value.

In the present invention, a double Kalman filtering algorithm is used. On one hand, the offline parameters and the Kalman filtering algorithm are used to estimate an SOC, and the Kalman algorithm is used, in combination with estimation results, to calculate the online parameters of the to-be-tested battery, and the online parameters are reused for SOC estimation by the Kalman filtering algorithm, forming a closed loop. The problems of accuracy reduction and an SOC jump, caused by only using the offline parameters to estimate an SOC, are solved, and influence of electric current accuracy and temperature, caused by only using an ampere-hour integration method, is reduced, thereby improving estimation accuracy and stability.

In another aspect, an embodiment of the present invention further provides an energy storage device, including: a battery SOC estimation device and an energy storage battery, where the battery SOC estimation device is configured to perform the battery SOC estimation method according to embodiments of the present invention.

**BRIEF DESCRIPTION OF DRAWINGS**

FIG. 1 is a schematic flowchart of an embodiment of a battery SOC estimation method provided in the present invention.

FIG. 2 is a schematic flowchart of another embodiment of a battery SOC estimation method provided in the present invention.

FIG. 3 is a schematic flowchart of an embodiment of an ampere-hour integration method provided in the present invention.

FIG. 4 is a schematic structural diagram of an embodiment of an equivalent circuit model provided in the present invention.

FIG. 5 is a schematic structural diagram of an embodiment of a battery SOC estimation apparatus provided in the present invention.

FIG. 6 is an operation strategy diagram of a battery SOC estimation method provided in the present invention.

## DESCRIPTION OF EMBODIMENTS

Hereinafter, the technical solutions in the embodiments of the present invention will be clearly and completely described with reference to the accompanying drawings in the embodiments of the present invention. Apparently, the described embodiments are only a part of the embodiments of the present invention, but not all the embodiments. Based on the embodiments of the present invention, all other embodiments obtained by those of ordinary skill in the art without making creative efforts shall fall within the protection scope of the present invention.

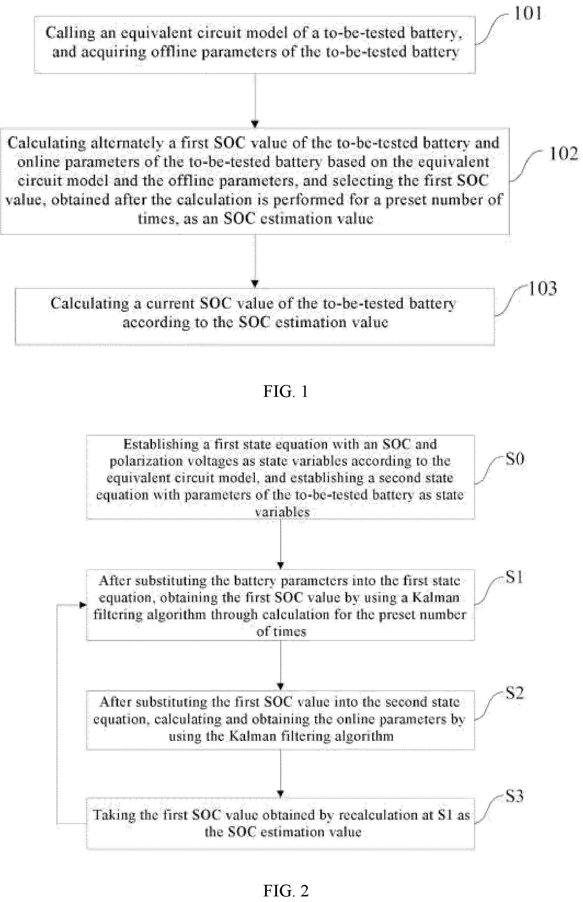

Reference please made to FIG. 1, which is a schematic flowchart of an embodiment of a battery SOC estimation method provided in the present invention, mainly including steps 101 to 103, as follows.

Step 101, calling an equivalent circuit model of a to-be-tested battery, and acquiring offline parameters of the to-be-tested battery.

In the embodiment, the equivalent circuit model is an RC equivalent circuit model, which is composed of several RC networks connected in series with ohmic internal resistances, and is used to simulate various internal resistances and polarization capacitances of the to-be-tested battery; the equivalent circuit model may adopt a first-order to third-order RC equivalent circuit model.

In the embodiment, the offline parameters of the to-be-tested battery include: open circuit voltage, ohmic internal resistance, polarization internal resistance and polarization capacitance under different SOCs.

Step 102, calculating alternately a first SOC value of the to-be-tested battery and online parameters of the to-be-tested battery based on the equivalent circuit model and the offline parameters, and selecting the first SOC value, obtained after the calculation is performed for a preset number of times, as an SOC estimation value.

In the embodiment, two algorithms of extended Kalman estimation SOC and extended Kalman estimation battery parameters transfer final output parameters to each other, and iteratively constitute a double Kalman filtering algorithm.

Step 103, calculating a current SOC value of the to-be-tested battery according to the SOC estimation value.

In the embodiment, step 103 specifically includes: according to the SOC estimation value, determining an ampere-hour integration coefficient of the to-be-tested battery during a charging-discharging process, where the SOC estimation value includes: a current SOC estimation value, a second SOC value corresponding to a highest cell voltage of the to-be-tested battery, and a third SOC value corresponding to a lowest cell voltage of the to-be-tested battery; and acquiring a current first current value of the to-be-tested battery, and performing an ampere-hour integration calculation according to the first current value and the ampere-hour integration coefficient, to obtain the current SOC value.

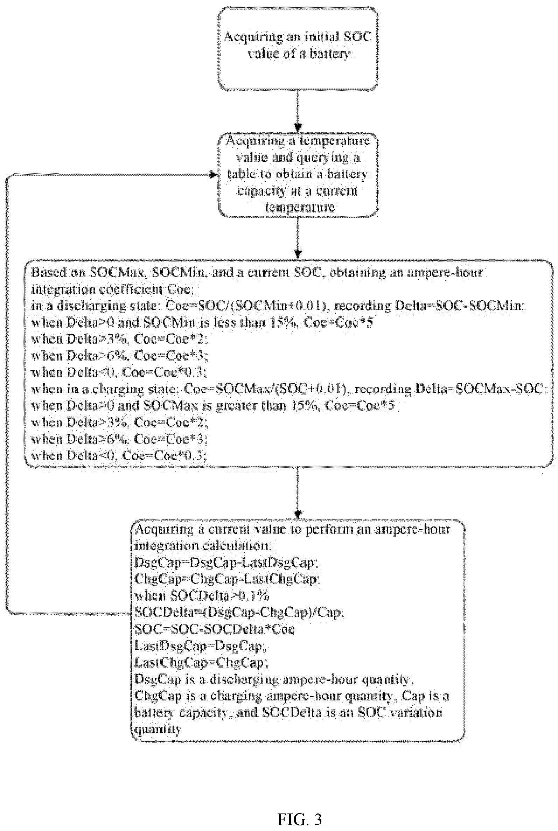

Reference please made to FIG. 3, which is a schematic flowchart of an embodiment of an ampere-hour integration method provided in the present invention. Here, in a discharging state of the to-be-tested battery, the ampere-hour integration coefficient $Coe = SOC/(SOCMin + 0.01)$, $SOC$ is the current SOC estimation value and $SOCMin$ is the third SOC value. In addition, a difference between the current SOC estimation value and the SOC minimum/maximum value is $Delta = SOC - SOCMin$. When Delta>0 and SOCMin<15%, the ampere-hour integration coefficient Coe=Coe*5. When Delta is greater than 3%, 6% and less than 0 respectively, the ampere-hour integration coefficient Coe is equal to Coe*2, Coe*3 and Coe*0.3 respectively. In a charging state of the to-be-tested battery, the ampere-hour integration coefficient $Coe = SOC/(SOCMax + 0.01)$, $SOC$ is the current SOC estimation value and SOCMax is the second SOC value. In addition, the difference between the current SOC estimation value and the SOC minimum/maximum value is Delta = SOCMax - SOC. When Delta>0 and SOCMax>15%, the ampere-hour integration coefficient Coe=Coe*5. When Delta is greater than 3%, 6% and less than 0 respectively, the ampere-hour integration coefficient Coe is equal to Coe*2, Coe*3 and Coe*0.3 respectively. After acquiring the current value of the to-be-tested battery, the ampere-hour integration calculation is performed. Here, a discharging ampere-hour quantity at the current time point and a charging ampere-hour quantity at the current time point are calculated in combination with a discharging ampere-hour quantity at the last time point and a charging ampere-hour quantity at the last time point. The discharging ampere-hour quantity is a charge quantity of the to-be-tested battery in the discharging process, and the charging ampere-hour quantity is a charge quantity of the to-be-tested battery in the charging process. When an SOC variation quantity >0.1%, the SOC variation quantity SocDelta = (DsgCap - ChgCap)/Cap, i.e., a ratio of the difference, between the discharging ampere-hour quantity and the charging ampere-hour quantity, to a battery capacity, whereas the current SOC value is the SOC estimation value minus the product of the SOC variation quantity and the ampere-hour integration coefficient.

In the embodiment, with the ampere-hour integration as a keynote, through adjusting the ampere-hour integration coefficient, the SOCMin obtained by a double Kalman filtering algorithm is gradually caught up during discharging, and the SOCMax is caught up during charging, which improves the accuracy of the SOC, while ensuring the stable change of the SOC.

In the present invention, firstly the double Kalman filtering algorithm is used to acquire the estimation result with relatively high accuracy, and then the current SOC of the to-be-tested battery is calculated by combining a time-based integration method, thus the technical problem of the estimation result being influenced by electric current accuracy and temperature, caused by only using the ampere-hour integration method, is solved.

Reference please made to FIG. 2, which is a schematic flowchart of another embodiment of a battery SOC estimation method provided in the present invention, mainly including steps S0 to S3, as follows.

In the embodiment, the step 102 specifically includes the steps S0 to S3.

S0, establishing a first state equation with an SOC and polarization voltages as state variables according to the equivalent circuit model, and establishing a second state equation with parameters of the to-be-tested battery as state variables.

In the embodiment, the establishing the first state equation with the SOC and the polarization voltages as the state variables according to the equivalent circuit model specifically includes: establishing a state space equation with an SOC of the equivalent circuit model and voltage parameters of the equivalent circuit model as variables; and according to the state space equation, establishing the first state equation of the equivalent circuit model. Here, the first state equation is

$$
\begin{bmatrix} U_1 \\ U_2 \\ U_3 \\ SOC \end{bmatrix} = \begin{bmatrix} 1-\frac{dt}{R_1 C_1} & 0 & 0 & 0 \\ 0 & 1-\frac{dt}{R_2 C_2} & 0 & 0 \\ 0 & 0 & 1-\frac{dt}{R_3 C_3} & 0 \\ 0 & 0 & 0 & 1 \end{bmatrix} * \begin{bmatrix} U_1^- \\ U_2^- \\ U_3^- \\ SOC^- \end{bmatrix} + \begin{bmatrix} \frac{dt}{C_1} \\ \frac{dt}{C_2} \\ \frac{dt}{C_3} \\ \frac{-dt}{cap} \end{bmatrix} * I .
$$

Here, $U_1$, $U_2$ and $U_3$ are respectively a first polarization voltage, a second polarization voltage and a third polarization voltage of the equivalent circuit model, $SOC$ is a charge state value of the to-be-tested battery, $R_1$, $R_2$ and $R_3$ are respectively an ohmic polarization internal resistance, an electrochemical polarization internal resistance and a concentration polarization internal resistance of the equivalent circuit model, $C_1$, $C_2$ and $C_3$ are respectively an ohmic polarization capacitance, an electrochemical polarization capacitance and a concentration polarization capacitance of the equivalent circuit model, $cap$ is a capacity of the to-be-tested battery, and $U_1^-$, $U_2^-$, $U_3^-$ and $SOC^-$ are a first polarization voltage at the calculation at the last time, a second polarization voltage at the calculation at the last time, a third polarization voltage at the calculation at the last time, and a charge state value at the calculation at the last time, respectively.

By combining the state equation and the Kalman filtering formula, it yields

$$
A = \begin{bmatrix} 1-\frac{dt}{R_1 C_1} & 0 & 0 & 0 \\ 0 & 1-\frac{dt}{R_2 C_2} & 0 & 0 \\ 0 & 0 & 1-\frac{dt}{R_3 C_3} & 0 \\ 0 & 0 & 0 & 1 \end{bmatrix}, \quad B = \begin{bmatrix} \frac{dt}{C_1} \\ \frac{dt}{C_2} \\ \frac{dt}{C_3} \\ \frac{-dt}{cap} \end{bmatrix}, \quad X = \begin{bmatrix} U_1 \\ U_2 \\ U_3 \\ SOC \end{bmatrix}, \quad U=I.
$$

In the embodiment, according to electrochemical characteristics, it has

$C_1 \frac{dt}{R_1 C_1} + \frac{U_1}{R_1} = I$ , after discretization it has $U_1 = U_1^- - \frac{U_1^-}{R_1 C_1} dt + \frac{I}{C_1} dt$ ;

$C_2 \frac{dt}{R_2 C_2} + \frac{U_2}{R_2} = I$ , after discretization it has $U_2 = U_2^- - \frac{U_2^-}{R_2 C_2} dt + \frac{I}{C_2} dt$ ;

$C_3 \frac{dU_3}{dt} + \frac{U_3}{R_3} = I$ , after discretization it has $U_3 = U_3^- - \frac{U_3^-}{R_3 C_3} dt + \frac{I}{C_3} dt$ ;

The voltage on the ohmic internal resistance is $U_0 = IR_0$, $R_0$ is the ohmic internal resistance and I is electric current passing through the to-be-tested battery; $SOC = SOC - \frac{I}{cap} dt$ , and cap is the battery capacity.

In the embodiment, the second state equation, that is, a state equation on battery parameters, is expressed as $\theta_{k+1} = \theta_k$. It can be obtained from the Kalman filtering formula: A is a $7\times7$ standard matrix, B=0, with state variables

$$X = \theta = \begin{bmatrix} R_0 \\ R_1 \\ R_2 \\ R_3 \\ C_1 \\ C_2 \\ C_3 \end{bmatrix}.$$

S1, SOC calculation: after substituting the battery parameters into the first state equation, obtaining the first SOC value by using a Kalman filtering algorithm through calculation for the preset number of times.

In the embodiment, the preset number of times is 20 to 100. In order to improve estimation efficiency, shorten estimation time and ensure timeliness, it is preferably 60.

In the embodiment, the step S1, the SOC calculation, specifically includes steps S11 to S15, as follows.

S11, acquiring an initial SOC value, and setting first initial values of the Kalman filtering algorithm based on the initial SOC value.

The first initial values include: $X = \begin{bmatrix} 0 \\ 0 \\ SOC \end{bmatrix}$, $P0 = \begin{bmatrix} 0.01 & 0 & 0 & 0 \\ 0 & 0.01 & 0 & 0 \\ 0 & 0 & 0.01 & 0 \\ 0 & 0 & 0 & 0.01 \end{bmatrix}$, Q=

$\begin{bmatrix} 0.00001 & 0 & 0 & 0 \\ 0 & 0.00001 & 0 & 0 \\ 0 & 0 & 0.00001 & 0 \\ 0 & 0 & 0 & 0.00001 \end{bmatrix}$ R=1.

Here, X is an initial value of a Kalman filtering state estimation vector, P0 is an initial value of an error covariance matrix, Q is a process excitation noise covariance, that is, white noise/system deviation, the Q value in this application is an accurate value after system adjustment, and R is a measurement noise covariance. In addition, the greater the process excitation noise covariance is, the greater a Kalman gain is; the smaller the measurement noise covariance is, the greater the Kalman gain is, and the stronger a calibration capability is.

S12, according to the first initial values and the battery parameters, calculating an SOC priori state value at a current time point and a first prior covariance at the current time point.

In the embodiment, the SOC priori state value $X_k = A * X_{k-1} + B * I$; where k is a time point of the calculation at the current time, and k-1 is a time point of the calculation at the last time. A posterior state value, obtained after the SOC priori state value is corrected by S13 to S15, is the first SOC value.

In the embodiment, the first prior covariance is $P = A * P0 * A' + Q$; where $A'$ is a transposed matrix of A.

S13, according to a first derivative of a voltage observation value and a voltage state value of the to-be-tested battery and the first prior covariance, calculating a first Kalman gain matrix at the current time point.

In the embodiment, the first Kalman gain matrix is $K = P * H'/(H = P * H' + R)$. Here, the first derivative

$H = \begin{bmatrix} -1 \\ -1 \\ -1 \\ der \end{bmatrix}$, the voltage observation value is an open circuit voltage of the to-be-tested battery, and the voltage state value is the SOC priori state value. The first derivative is a derivative of the open circuit voltage of the to-be-tested battery with respect to the SOC priori state value, and der is a derivative of the open circuit voltage, OCV, with respect to SOC, which is expressed as an array der[20] obtained by using a discrete manner, $der[n] = (OCV1 - OCV2)/5\%$. Here, OCV1 is an OCV voltage at 5*n%SOC, OCV2 is an OCV voltage at 5*(n-1)%SOC, and a value range of n is 1 to 20. The OCV voltage is calculated at a point of every 5%, OCV is battery power after discharging 5% from full power and standing for one hour, der[20]=(100%OCV-95%OCV)/5%, der[19]=(95%OCV-90%OCV)/5%, and so on, der[1]=(5%OCV-0%OCV)/5%. $H'$ is a transposed matrix of H.

S14, calculating a terminal voltage at the current time point according to the SOC priori state value, an open circuit voltage of the equivalent circuit model and an ohmic internal resistance of the equivalent circuit model.

In the embodiment, the terminal voltage at the current time point is $G = OCV + C * X - I * R_0$. Here, $C = \begin{bmatrix} -1 \\ -1 \\ -1 \\ 0 \end{bmatrix}$,

and the OCV is an OCV value corresponding to an SOC, obtained according to the current SOC priori state value.

S15, updating an SOC state value and a covariance according to the terminal voltage, the SOC priori state value and the first Kalman gain matrix.

S16, judging whether a number of times for execution of the step of the first parameter calculation reaches a preset number of calculation times; when the number of times for execution reaches the preset number of calculation times, performing step S17; and when the number of times for execution does not reach the preset number of calculation times, returning to S12.

S17, setting an updated SOC state value to the first SOC value.

In the embodiment, the posterior state value obtained after the SOC state value is updated is $X = X + K * (Volt - G)$. Here, *Volt* is a voltage of the to-be-tested battery obtained by actual sampling, and the posterior state value obtained by calculation is the first SOC value.

In the embodiment, an update of the posterior covariance is expressed as $P0 = (eye(4) - K * H) * P$, where $eye(4)$ is a standard 4×4 matrix.

In the embodiment of the present application, through continuous estimation of the SOC of the to-be-tested battery through the offline parameters and the continuously updated online parameters, the problems of gradual reduction of estimation accuracy and jumps of estimation results, caused along with a decrease of battery performance, caused by only using the offline parameters, are solved.

S2, after substituting the first SOC value into the second state equation, calculating and obtaining the online parameters by using the Kalman filtering algorithm.

In the embodiment, the step S2 specifically includes steps S21 and S22, as follows.

S21, setting second initial values of the Kalman filtering algorithm according to the first SOC value.

In the embodiment, the second initial values include: $dx\_0 =$

$$
\begin{bmatrix} 0 & 0 & 0 & 0 & 0 & 0 & 0 \\ 0 & 0 & 0 & 0 & 0 & 0 & 0 \\ 0 & 0 & 0 & 0 & 0 & 0 & 0 \\ 0 & 0 & 0 & 0 & 0 & 0 & 0 \end{bmatrix}, \quad
\theta = \begin{bmatrix} R_0\mathrm{Init} \\ R_1\mathrm{Init} \\ R_2\mathrm{Init} \\ R_3\mathrm{Init} \\ C_1\mathrm{Init} \\ C_2\mathrm{Init} \\ C_3\mathrm{Init} \end{bmatrix}, \quad
P0 = \begin{bmatrix} 1 & 0 & 0 & 0 & 0 & 0 & 0 \\ 0 & 0.01 & 0 & 0 & 0 & 0 & 0 \\ 0 & 0 & 1 & 0 & 0 & 0 & 0 \\ 0 & 0 & 0 & 0.01 & 0 & 0 & 0 \\ 0 & 0 & 0 & 0 & 1 & 0 & 0 \\ 0 & 0 & 0 & 0 & 0 & 0.01 & 0 \\ 0 & 0 & 0 & 0 & 0 & 0 & 1 \end{bmatrix},
$$

$$
Q = \begin{bmatrix}
0.0000003 & 0 & 0 & 0 & 0 & 0 & 0 \\
0 & 0.0000003 & 0 & 0 & 0 & 0 & 0 \\
0 & 0 & 1000000000 & 0 & 0 & 0 & 0 \\
0 & 0 & 0 & 0.00000003 & 0 & 0 & 0 \\
0 & 0 & 0 & 0 & 1000000000 & 0 & 0 \\
0 & 0 & 0 & 0 & 0 & 0.00000003 & 0 \\
0 & 0 & 0 & 0 & 0 & 0 & 1000000000
\end{bmatrix}, \quad R = 5000.
$$

S22, calculating iteratively a second derivative of a voltage observation value with respect to a voltage state value of the to-be-tested battery. In the embodiment, the second derivative is expressed as $H = \dfrac{dG}{d\theta} = \dfrac{\partial G}{\partial \theta} + \dfrac{\partial G}{\partial X} * \dfrac{dX}{d\theta}$. By simplifing the second derivative, it yields $\dfrac{dX_k}{d\theta} = C2 + A * \dfrac{dX_{k-1}}{d\theta}$, $H = C1 + H\_1 * \dfrac{dX}{d\theta}$,

$\dfrac{dX_{k+1}}{d\theta} = \dfrac{dX_k}{d\theta} - k_k * H_k$ ; where, $C1 = \left[ -I \quad -\dfrac{X(1)^- * dt}{R_1 R_1 C_1} \quad -\dfrac{X(1)^- * dt}{R_1 C_1 C_1} + \dfrac{Idt}{C_1 C_1} \quad -\dfrac{X(2)^- * dt}{R_2 R_2 C_2} \right. -$

$\dfrac{X(2)^- * dt}{R_2 C_2 C_2} + \dfrac{Idt}{C_2 C_2} \quad -\dfrac{X(3)^- * dt}{R_3 R_3 C_3} \quad \left. -\dfrac{X(3)^- * dt}{R_3 C_3 C_3} + \dfrac{Idt}{C_3 C_3} \right]$ , $H\_1 = \begin{bmatrix} -1 \\ -1 \\ -1 \\ der \end{bmatrix}$ , $C2 =$

$$
\begin{bmatrix}
0 & \dfrac{U_1^- * dt}{R_1 R_1 C_1} & \dfrac{U_1^- * dt}{R_1 C_1 C_1} - \dfrac{Idt}{C_1 C_1} & 0 & 0 & 0 & 0 \\
0 & 0 & 0 & \dfrac{U_2^- * dt}{R_2 R_2 C_2} & \dfrac{U_2^- * dt}{R_2 C_2 C_2} - \dfrac{Idt}{C_2 C_2} & 0 & 0 \\
0 & 0 & 0 & 0 & 0 & \dfrac{U_3^- * dt}{R_3 R_3 C_3} & \dfrac{U_3^- * dt}{R_2 C_3 C_3} - \dfrac{Idt}{C_3 C_3} \\
0 & 0 & 0 & 0 & 0 & 0 & 0
\end{bmatrix}
$$

; and $H\_1$ is the first derivative.

S23, calculating priori state values of the parameters of the to-be-tested battery and a second prior covariance according to the second initial values.

In the embodiment, the priori state values of the battery parameters $\theta_1 = \theta$, and the second prior covariance is $P = P0 + Q$.

S24, calculating a second Kalman gain matrix according to the second prior covariance and the second derivative.

In the embodiment, the second Kalman gain is $K = P * H'/(H * P * H' + R)$. Here, $H'$ is a transposed matrix of $H$.

S25, updating state values of the parameters of the to-be-tested battery and a covariance according to the second prior covariance, the second Kalman gain matrix and the second derivative, to obtain the online parameters, and returning to S22.

In the embodiment, the updated state values of the parameters of the to-be-tested battery $\theta_2 = \theta + K * (Volt - G)$. Here, Volt is the voltage of the to-be-tested battery obtained by actual sampling, and G is the terminal voltage at the current time point. The updated state values of the parameters of the to-be-tested battery are the online parameters, which are used for performing the step S1 at next time. The updated covariance is $P0 = (eye(7) - K * H) * P$, where $eye(7)$ is a $7 \times 7$ matrix.

In the present invention, according to the SOC estimated by the Kalman filtering algorithm, the battery parameters are used as variables of a dynamic equation for calculation, which realizes estimation and updating of the online parameters, and the updated parameters are reused in the step S12 to realize loop iteration. The problems of gradual reduction of accuracy and jumps of estimation results caused by only using the offline parameters, when using the Kalman filtering algorithm to estimate the SOC, are solved.

S3, returning to S1, and taking the first SOC value obtained by recalculation as the SOC estimation value, where the battery parameters include the offline parameters and online parameters obtained by last calculation.

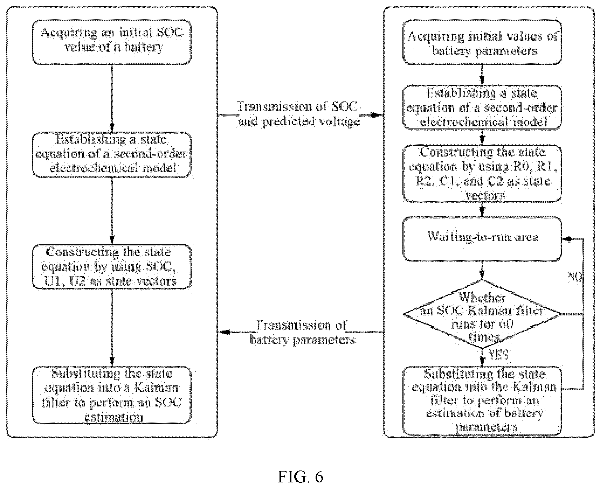

Reference please made to FIG. 6, which is an operation strategy diagram of a battery SOC estimation method provided in the present invention. Here, in the steps S11 to S17, the SOC, i.e., the first SOC value, and the predicted voltage, i.e., the terminal voltage at the current time point, are transmitted for the steps S21 to S25. In the steps S21 to S25, the battery parameters, i.e., the online parameters, are transmitted for the steps S11 to S15. Furthermore, after the calculation is performed for the preset number of times in S21 to S25, e.g., performing the calculation for 60 times, the first SOC value is then transmitted to the steps S21 to S25, which can ensure calculation accuracy and calculation efficiency of the first SOC value.

In the present invention, the SOC of the to-be-tested battery is estimated by using the Kalman filtering algorithm according to the offline parameters or the online parameters. In addition, the Kalman filtering algorithm is further used to update the online parameters according to the estimated SOC, and loop iteration is performed. The problems of gradual reduction of estimation accuracy and jumps of estimation results caused by only using the Kalman filtering algorithm are solved.

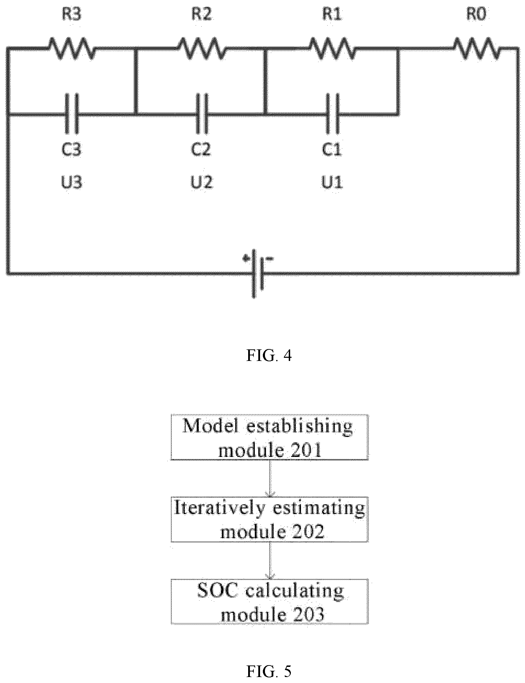

Reference please made to FIG. 4, which is a schematic structural diagram of an embodiment of an equivalent circuit model provided in the present invention. Here, the equivalent circuit model is a third-order RC equivalent circuit model. The third-order RC equivalent circuit model is used for simulating a circuit, which includes: ohmic internal resistance R0, ohmic polarization internal resistance R1, electrochemical polarization internal resistance R2, concentration polarization internal resistance R3, ohmic polarization capacitance C1, electrochemical polarization capacitance C2 and concentration polarization capacitance C3;

Here, the ohmic polarization internal resistance R1 and the ohmic polarization capacitance C1 are connected in parallel to form a first RC network;

the electrochemical polarization resistance R2 and the electrochemical polarization capacitance C2 are connected in parallel to form a second RC network;
the concentration polarization internal resistance R3 and the concentration polarization capacitance C3 are connected in parallel to form a third RC network;
the ohmic resistance R0, the first RC network, the second RC network, the third RC network and a voltage source are connected in series.

In the present invention, the third-order RC equivalent circuit model is used, compared with the prior art using a second-order model, the state of the to-be-tested battery can be better reflected, and the accuracy of the estimation result is higher.

Further, the acquiring the offline parameters of the to-be-tested battery specifically includes:
performing an HPPC test on the to-be-tested battery at a preset temperature point, and acquiring the offline parameters of the to-be-tested battery under different SOCs.

In the embodiment, the temperature point is selected from a range of 0°C to 60°C, preferably five temperature points of 0°C, 10°C, 15°C, 25°C, 35°C and 45°C. 5% SOC is taken as one point to perform 1C charging-discharging, and each time the charging-discharging is completed, it is left to stand for one hour. According to the HPPC test data, the open circuit voltage, ohmic internal resistance, polarization resistance, polarization capacitance, concentration polarization resistance and concentration polarization capacitance of the second-order electrochemical model at different temperatures and different SOCs can be obtained.

Reference please made to FIG. 5, which is a schematic structural diagram of an embodiment of a battery SOC estimation apparatus provided in the present invention, mainly includes: a parameter acquiring module 201, an iteratively estimating module 202 and an SOC calculating module 203.

In the embodiment, the parameter acquiring module 201 is configured to call an equivalent circuit model of a to-be-tested battery, and acquire offline parameters of the to-be-tested battery.

The iteratively estimating module 202 is configured to calculate alternately a first SOC value of the to-be-tested battery and online parameters of the to-be-tested battery based on the equivalent circuit model and the offline parameters, and select the first SOC value, obtained after the calculation is performed for a preset number of times, as an SOC estimation value.

In the embodiment, the iteratively estimating module 202 includes: an equation establishing unit, a first Kalman filtering unit, a second Kalman filtering unit and an estimation result outputting unit, where the equation establishing unit is configured to establish a first state equation with an SOC and polarization voltages as state variables according to the equivalent circuit model, and establish a second state equation with parameters of the to-be-tested battery as state variables; the first Kalman filtering unit is configured to, after substituting the battery parameters into the first state equation, obtain the first SOC value by using a Kalman filtering algorithm through calculation for the preset number of times; the second Kalman filtering unit is configured to, after substituting the first SOC value into the second state equation, calculate and obtain the online parameters by using the Kalman filtering algorithm; and the estimation result outputting unit is configured to return to the performance of the first Kalman filtering unit, and take the first SOC value obtained by recalculation as the SOC estimation value, where the battery parameters include the offline parameters and online parameters obtained by last calculation.

The SOC calculating module 203 is configured to calculate a current SOC value of the to-be-tested battery according to the SOC estimation value.

In another aspect, an embodiment of the present invention further provides an energy storage device, including: a battery SOC estimation device and an energy storage battery, where the battery SOC estimation device is configured to perform the battery SOC estimation method according to the embodiments of the present invention.

In the present invention, a double Kalman filtering algorithm is used. On one hand, the offline parameters and the Kalman filtering algorithm are used to estimate an SOC, and the Kalman algorithm is used, in combination with estimation results, to calculate the online parameters of the to-be-tested battery, and the online parameters are reused for SOC estimation by the Kalman filtering algorithm, forming a closed loop. The problems of accuracy reduction and an SOC jump, caused by only using the offline parameters to estimate an SOC, are solved, and influence of electric current accuracy and temperature, caused by only using an ampere-hour integration method, is reduced, thereby improving estimation accuracy and stability.

The above specific embodiments further describe the objectives, technical solutions and beneficial effects of the present invention in detail, and it should be understood that the above are only specific embodiments of the present invention, and are not intended to limit the protection scope of the present invention. It is particularly pointed out that for those skilled in the art, any modification, equivalent replacement, improvement and the like made within the spirit and principle of the present invention should be included in the protection scope of the present invention.

**Claims**

1. A battery SOC estimation method, comprising:

   calling an equivalent circuit model of a to-be-tested battery, and acquiring offline parameters of the to-be-tested battery;
   calculating alternately a first SOC value of the to-be-tested battery and online parameters of the to-be-tested battery based on the equivalent circuit model and the offline parameters, and selecting the first SOC value, obtained after the calculation is performed for a preset number of times, as an SOC estimation value; and
   calculating a current SOC value of the to-be-tested battery according to the SOC estimation value.

2. The battery SOC estimation method according to claim 1, wherein the calculating alternately the first SOC value of the to-be-tested battery and the online parameters of the to-be-tested battery based on the equivalent circuit model and the offline parameters, and selecting the first SOC value, obtained after the calculation is performed for the preset number of times, as the SOC estimation value specifically comprises:

establishing a first state equation with an SOC and polarization voltages as state variables according to the equivalent circuit model, and establishing a second state equation with parameters of the to-be-tested battery as state variables;
SOC calculation: after substituting the battery parameters into the first state equation, obtaining the first SOC value by using a Kalman filtering algorithm through calculation for the preset number of times;
after substituting the first SOC value into the second state equation, calculating and obtaining the online parameters by using the Kalman filtering algorithm; and
returning to the step of the SOC calculation, and taking the first SOC value obtained by recalculation as the SOC estimation value, wherein the battery parameters comprise the offline parameters and online parameters obtained by last calculation.

3. The battery SOC estimation method according to claim 2, wherein the establishing the first state equation with the SOC and the polarization voltages as the state variables according to the equivalent circuit model specifically comprises:

establishing a state space equation with an SOC of the equivalent circuit model and voltage parameters of the equivalent circuit model as variables; and
according to the state space equation, establishing the first state equation of the equivalent circuit model.

4. The battery SOC estimation method according to claim 2, wherein the after substituting the battery parameters into the first state equation, calculating and obtaining the first SOC value by using the Kalman filtering algorithm specifically comprises:

acquiring an initial SOC value, and setting first initial values of the Kalman filtering algorithm based on the initial SOC value;
first parameter calculation: according to the first initial values and the battery parameters, calculating an SOC priori state value at a current time point and a first prior covariance at the current time point;
according to a first derivative of a voltage observation value and a voltage state value of the to-be-tested battery and the first prior covariance, calculating a first Kalman gain matrix at the current time point;
calculating a terminal voltage at the current time point according to the SOC priori state value, an open circuit voltage of the equivalent circuit model and an ohmic internal resistance of the equivalent circuit model;
updating an SOC state value and a covariance according to the terminal voltage, the SOC priori state value and the first Kalman gain matrix;
judging whether a number of times for execution of the step of the first parameter calculation reaches a preset number of calculation times;
when the number of times for execution reaches the preset number of calculation times, setting an updated SOC state value to the first SOC value; and
when the number of times for execution does not reach the preset number of calculation times, returning to the step of the first parameter calculation.

5. The battery SOC estimation method according to claim 2, wherein the after substituting the first SOC value into the second state equation, calculating and obtaining the online parameters by using the Kalman filtering algorithm specifically comprises:

setting second initial values of the Kalman filtering algorithm according to the first SOC value;
second parameter calculation: calculating iteratively a second derivative of a voltage observation value with respect to a voltage state value of the to-be-tested battery;
calculating priori state values of the parameters of the to-be-tested battery and a second prior covariance according to the second initial values;
calculating a second Kalman gain matrix according to the second prior covariance and the second derivative; and
updating state values of the parameters of the to-be-tested battery and a covariance according to the second prior covariance, the second Kalman gain matrix and the second derivative, to obtain the online parameters, and returning to the step of the second parameter calculation.

6. The battery SOC estimation method according to claim 1, wherein the calculating the current SOC value of the to-be-tested battery according to the SOC estimation value specifically comprises:

according to the SOC estimation value, determining an ampere-hour integration coefficient of the to-be-tested battery during a charging-discharging process, wherein the SOC estimation value comprises: a current SOC estimation value, a second SOC value corresponding to a highest cell voltage of the to-be-tested battery and a third SOC value corresponding to a lowest cell voltage of the to-be-tested battery; and

acquiring a current first current value of the to-be-tested battery, and performing an ampere-hour integration calculation according to the first current value and the ampere-hour integration coefficient, to obtain the current SOC value.

7. The battery SOC estimation method according to any one of claims 1-6, wherein the equivalent circuit model is a third-order RC equivalent circuit model.

8. The battery SOC estimation method according to any one of claims 1-6, wherein the acquiring the offline parameters of the to-be-tested battery specifically comprises:
performing an HPPC test on the to-be-tested battery at a preset temperature point, and acquiring the offline parameters of the to-be-tested battery under different SOCs.

9. An apparatus applying the battery SOC estimation method according to any one of claims 1-8, comprising:

a parameter acquiring module, configured to call an equivalent circuit model of a to-be-tested battery, and acquire offline parameters of the to-be-tested battery;
an iteratively estimating module, configured to calculate alternately a first SOC value of the to-be-tested battery and online parameters of the to-be-tested battery based on the equivalent circuit model and the offline parameters, and select the first SOC value, obtained after the calculation is performed for a preset number of times, as an SOC estimation value; and
an SOC calculating module, configured to calculate a current SOC value of the to-be-tested battery according to the SOC estimation value.

10. An energy storage device, comprising: a battery SOC estimation device and an energy storage battery, wherein the battery SOC estimation device is configured to perform the battery SOC estimation method according to any one of claims 1-8.

Calling an equivalent circuit model of a to-be-tested battery, and acquiring offline parameters of the to-be-tested battery — 101

Calculating alternately a first SOC value of the to-be-tested battery and online parameters of the to-be-tested battery based on the equivalent circuit model and the offline parameters, and selecting the first SOC value, obtained after the calculation is performed for a preset number of times, as an SOC estimation value — 102

Calculating a current SOC value of the to-be-tested battery according to the SOC estimation value — 103

FIG. 1

Establishing a first state equation with an SOC and polarization voltages as state variables according to the equivalent circuit model, and establishing a second state equation with parameters of the to-be-tested battery as state variables — S0

After substituting the battery parameters into the first state equation, obtaining the first SOC value by using a Kalman filtering algorithm through calculation for the preset number of times — S1

After substituting the first SOC value into the second state equation, calculating and obtaining the online parameters by using the Kalman filtering algorithm — S2

Taking the first SOC value obtained by recalculation at S1 as the SOC estimation value — S3

FIG. 2

Acquiring an initial SOC value of a battery

Acquiring a temperature value and querying a table to obtain a battery capacity at a current temperature

Based on SOCMax, SOCMin, and a current SOC, obtaining an ampere-hour integration coefficient Coe;
in a discharging state: Coe=SOC/(SOCMin+0.01), recording Delta=SOC-SOCMin;
when Delta>0 and SOCMin is less than 15%, Coe=Coe*5
when Delta>3%, Coe=Coe*2;
when Delta>6%, Coe=Coe*3;
when Delta<0, Coe=Coe*0.3;
when in a charging state: Coe=SOCMax/(SOC+0.01), recording Delta=SOCMax-SOC;
when Delta>0 and SOCMax is greater than 15%, Coe=Coe*5
when Delta>3%, Coe=Coe*2;
when Delta>6%, Coe=Coe*3;
when Delta<0, Coe=Coe*0.3;

Acquiring a current value to perform an ampere-hour integration calculation:
DsgCap=DsgCap-LastDsgCap;
ChgCap=ChgCap-LastChgCap;
when SOCDelta>0.1%
SOCDelta=(DsgCap-ChgCap)/Cap;
SOC=SOC-SOCDelta*Coe
LastDsgCap=DsgCap;
LastChgCap=ChgCap;
DsgCap is a discharging ampere-hour quantity,
ChgCap is a charging ampere-hour quantity, Cap is a battery capacity, and SOCDelta is an SOC variation quantity

FIG. 3

FIG. 4

FIG. 5

```
┌─────────────────────────────┐          ┌──────────────────────────────┐
│ ┌─────────────────────────┐ │          │ ┌──────────────────────────┐ │
│ │  Acquiring an initial SOC│ │          │ │ Acquiring initial values of│ │
│ │     value of a battery   │ │          │ │    battery parameters     │ │
│ └─────────────────────────┘ │          │ └──────────────────────────┘ │
│            │                │          │            │                 │
│            ▼                │  Transmission of SOC  │            ▼                 │
│ ┌─────────────────────────┐ │  and predicted voltage│ ┌──────────────────────────┐ │
│ │    Establishing a state  │ │ ────────────────────► │ │    Establishing a state   │ │
│ │  equation of a second-order│          │ │ equation of a second-order│ │
│ │   electrochemical model  │ │          │ │   electrochemical model   │ │
│ └─────────────────────────┘ │          │ └──────────────────────────┘ │
│            │                │          │            │                 │
│            ▼                │          │            ▼                 │
│ ┌─────────────────────────┐ │          │ ┌──────────────────────────┐ │
│ │   Constructing the state │ │          │ │  Constructing the state   │ │
│ │  equation by using SOC,  │ │          │ │ equation by using R0, R1, │ │
│ │   U1, U2 as state vectors│ │          │ │ R2, C1, and C2 as state   │ │
│ └─────────────────────────┘ │          │ │        vectors           │ │
│            │                │          │ └──────────────────────────┘ │
│            ▼                │  Transmission of │      │                 │
│ ┌─────────────────────────┐ │  battery parameters │ ┌──────────────┐    │
│ │  Substituting the state  │ │ ◄───────────────│ │Waiting-to-run area│   │
│ │ equation into a Kalman   │ │          │ └──────────────┘    │
│ │  filter to perform an SOC│ │          │      │          NO │
│ │       estimation         │ │          │      ▼             │
│ └─────────────────────────┘ │          │   ╱Whether╲        │
└─────────────────────────────┘          │  ╱ an SOC Kalman╲───┘
                                         │  ╲ filter runs for 60 ╱
                                         │   ╲ times  ╱
                                         │      │ YES
                                         │      ▼
                                         │ ┌──────────────────────────┐
                                         │ │  Substituting the state   │
                                         │ │ equation into the Kalman  │
                                         │ │  filter to perform an     │
                                         │ │ estimation of battery     │
                                         │ │     parameters           │
                                         │ └──────────────────────────┘
                                         └──────────────────────────────┘
```

FIG. 6

## INTERNATIONAL SEARCH REPORT

| International application No. |
| --- |
| **PCT/CN2024/100881** |

**A. CLASSIFICATION OF SUBJECT MATTER**

G01R31/367(2019.01)i；G01R31/387(2019.01)i

According to International Patent Classification (IPC) or to both national classification and IPC

**B. FIELDS SEARCHED**

Minimum documentation searched (classification system followed by classification symbols)

IPC：G01R

Documentation searched other than minimum documentation to the extent that such documents are included in the fields searched

Electronic data base consulted during the international search (name of data base and, where practicable, search terms used)

CNABS; CNTXT; CNKI; VEN; WOTXT; EPTXT; USTXT; IEEE: 浙江艾罗网络能源, 姚震飞, 宋苏, 蒋飞, 周瑜, 电池, 荷电状态, 剩余容量, 卡尔曼滤波, 安时积分, 离线参数, 在线参数, 单体电压, 最高, 最大, 最低, 最小, 先验协方差, 先验状态值, 导数, SOC, +KF, Ah, batter+, state of charge, kalman filter+, ampere-hour, integrat+

**C. DOCUMENTS CONSIDERED TO BE RELEVANT**

| Category* | Citation of document, with indication, where appropriate, of the relevant passages | Relevant to claim No. |
| --- | --- | --- |
| PX | CN 116718928 A (SOLAX POWER NETWORK (ZHEJIANG) TECHNOLOGY CO., LTD.) 08 September 2023 (2023-09-08) claims 1-10 | 1-10 |
| X | CN 112858928 A (ANHUI UNIVERSITY OF SCIENCE & TECHNOLOGY) 28 May 2021 (2021-05-28) description, paragraphs [0072]-[0130] | 1-5, 7-10 |
| Y | CN 112858928 A (ANHUI UNIVERSITY OF SCIENCE & TECHNOLOGY) 28 May 2021 (2021-05-28) description, paragraphs [0072]-[0130] | 6-10 |
| Y | CN 115524620 A (ZHUHAI GUANGTONG AUTOMOBILE CO., LTD. et al.) 27 December 2022 (2022-12-27) description, paragraphs [0062]-[0101] | 6-10 |
| A | CN 106814329 A (SHENZHEN MILLENNIAL INNOVATION & TECHNOLOGY CO., LTD.) 09 June 2017 (2017-06-09) entire document | 1-10 |

☑ Further documents are listed in the continuation of Box C.     ☑ See patent family annex.

| | | |
| --- | --- | --- |
| \* | Special categories of cited documents: | |
| "A" | document defining the general state of the art which is not considered to be of particular relevance | |
| "D" | document cited by the applicant in the international application | |
| "E" | earlier application or patent but published on or after the international filing date | |
| "L" | document which may throw doubts on priority claim(s) or which is cited to establish the publication date of another citation or other special reason (as specified) | |
| "O" | document referring to an oral disclosure, use, exhibition or other means | |
| "P" | document published prior to the international filing date but later than the priority date claimed | |

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
| --- | --- |
| **05 August 2024** | **14 August 2024** |

| Name and mailing address of the ISA/CN | Authorized officer |
| --- | --- |
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**EP 4 607 215 A1**

## INTERNATIONAL SEARCH REPORT

| | International application No. |
| --- | --- |
| | **PCT/CN2024/100881** |

### C. DOCUMENTS CONSIDERED TO BE RELEVANT

| Category* | Citation of document, with indication, where appropriate, of the relevant passages | Relevant to claim No. |
| --- | --- | --- |
| A | CN 107390127 A (SUNWODA ELECTRIC VEHICLE BATTERY CO., LTD.) 24 November 2017 (2017-11-24)<br>entire document | 1-10 |
| A | CN 111505506 A (JILIN UNIVERSITY) 07 August 2020 (2020-08-07)<br>entire document | 1-10 |
| A | CN 115308604 A (HANGZHOU JIEMA ENERGY TECHNOLOGY CO., LTD.) 08 November 2022 (2022-11-08)<br>entire document | 1-10 |
| A | CN 115951248 A (SOUTH CHINA UNIVERSITY OF TECHNOLOGY et al.) 11 April 2023 (2023-04-11)<br>entire document | 1-10 |
| A | CN 116125278 A (WUHAN INSTITUTE OF TECHNOLOGY) 16 May 2023 (2023-05-16)<br>entire document | 1-10 |
| A | WO 2006057468 A1 (LG CHEMICAL LTD.) 01 June 2006 (2006-06-01)<br>entire document | 1-10 |

Form PCT/ISA/210 (second sheet) (July 2022)

18

## INTERNATIONAL SEARCH REPORT
### Information on patent family members

| Patent document cited in search report | | | Publication date (day/month/year) | Patent family member(s) | Publication date (day/month/year) |
|---|---|---|---|---|---|
| CN | 116718928 | A | 08 September 2023 | None | |
| CN | 112858928 | A | 28 May 2021 | None | |
| CN | 115524620 | A | 27 December 2022 | None | |
| CN | 106814329 | A | 09 June 2017 | None | |
| CN | 107390127 | A | 24 November 2017 | None | |
| CN | 111505506 | A | 07 August 2020 | None | |
| CN | 115308604 | A | 08 November 2022 | None | |
| CN | 115951248 | A | 11 April 2023 | None | |
| CN | 116125278 | A | 16 May 2023 | None | |
| WO | 2006057468 | A1 | 01 June 2006 | None | |

Form PCT/ISA/210 (patent family annex) (July 2022)

REFERENCES CITED IN THE DESCRIPTION

**Patent documents cited in the description**

- CN 202310884347